(19) Europäisches Patentamt
European Patent Office
Office européen des brevets

(11) EP 4 632 401 A1

(12) **EUROPEAN PATENT APPLICATION**

(43) Date of publication:
15.10.2025 Bulletin 2025/42

(51) International Patent Classification (IPC):
$G01R\ 31/367^{(2019.01)}$ $\quad$ $G01R\ 31/389^{(2019.01)}$
$G01R\ 31/392^{(2019.01)}$ $\quad$ $H01M\ 10/48^{(2006.01)}$

(21) Application number: 24169779.6

(22) Date of filing: 11.04.2024

(52) Cooperative Patent Classification (CPC):
G01R 31/389; G01R 31/367; G01R 31/392;
H01M 10/48

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: AVL List GmbH
8020 Graz (AT)

(72) Inventor: Gregorcic, Gregor
8047 Graz (AT)

(74) Representative: Patentanwälte Pinter & Weiss OG
Prinz-Eugen-Straße 70
1040 Wien (AT)

(54) **METHOD AND IDENTIFICATION UNIT FOR IDENTIFYING AN IMPEDANCE-VALUE OF AN ELECTROCHEMICAL ENERGY STORAGE**

(57) In order to provide a method that allows to more accurately and more efficiently determine an impedance-model for an electrochemical energy storage, at least one excitation-signal-component (usin) with a pre-defined excitation-component-frequency (fu) is generated and applied to said electrochemical energy storage (C), a response signal (y) of the electrochemical energy storage (C) is measured, a first cost function value ($J_1$) is determined, at least one correction factor (A1) to obtain a corrected-signal-component (rsin) from the response-signal-component (ysin) is determined, a deviation ($e_{ur}$) between the corrected-signal-component (rsin) and the excitation-signal-component (usin) in the identification interval (I) being associated with a second cost function value ($J_2$) smaller than the first cost function value ($J_2 < J_1$), and an impedance-value (Z) to describe the electrochemical energy storage (C) at the excitation-component-frequency (fu) from the at least one correction factor (A1) is determined.

Fig. 3

EP 4 632 401 A1

**Description**

The present invention pertains to a method and to an identification unit for identifying an impedance-value of an electrochemical energy storage. Further, the present invention pertains to an electrochemical energy storage, as well as to an arrangement of an electrochemical energy storage with an identification unit.

Electrochemical energy storages typically comprise a large number of individual electrochemical cells, the cells being connected in series and/or in parallel. Electrochemical energy storages, such as primary batteries (e.g., small disposable batteries), secondary batteries (e.g., rechargeable batteries) or fuel cells are increasingly used in many different settings, from powering portable electronic devices to fully or partially powering electric vehicles. With the increased use of electrochemical energy storages, also the need for longer life of an energy storage and consequently of its cells becomes more important.

Many factors impact the ability of an electrochemical energy storage to provide high performance over its lifespan. For example, chemical changes to electrodes in a rechargeable battery may cause degradation in the battery's capacity. Moreover, also environmental factors (e.g., high temperature) and functional factors (e.g., improper charging and discharging) may lead to the degradation of an electrochemical energy storage. Therefore, operators of systems that rely on power drawn from electrochemical energy storages desire to closely monitor the degradation of the energy storage they use. When monitoring an energy storage, operators typically are keen to be well-informed on the so-called state-of-health (SoH) of the electrochemical cells in the electrochemical energy storage, the SoH being a figure of merit of the condition of a cell compared to its ideal conditions. Accurate information on a cell's SoH allows for modifications of an operating strategy in case of potential damages or degradation. An important indicator of cell degradation and SoH is a cell's and thus an energy storage's impedance.

When manufacturing electrochemical cells, it is well known to derive impedance-models by Electrochemical Impedance Spectroscopy (EIS) measurements before the cell is put in use. However, in the context of continued use of a cell, such as the continued use in a Lithium-Ion-battery of an electric vehicle, where the cell and thus the battery should last many years, models derived from EIS measurements during production may become inaccurate over time. Initial, but also continued characterizations of an energy storage's state of health are thus needed in many contexts. Consequently, this issue is also addressed in the prior art.

US 10,345,384 B2, for instance, teaches an impedance measurement device, allowing to apply an excitation current signal to a battery including a plurality of pulses exhibiting a great number of different amplitudes. A response to this signal is measured and a new excitation amplitude is computed, based on an analysis of the reaction to all the different amplitudes. US 10,345,384 B2 thus requires several complex and elaborate analysis steps, in order to find the new amplitude.

US 10, 386, 422 B2 teaches a method of determining a State-of-Health (SoH) and/or State-of-Charge (SoC) of a rechargeable battery during charging and discharging of the battery, by applying two different excitation signals to the battery. The need to generate and apply at least two excitation signals, as well as to analyze the responses to both of these signals significantly complicates the teachings of US 10, 386, 422 B2.

Hence, the methods known from the prior art suffer from certain drawbacks, mainly associated with high complexity and a lack of efficiency. It is thus an object of the present invention to provide a method of more accurately and more efficiently determining an impedance-model for an electrochemical energy storage, applicable also during actual use of the storage.

This object, for the method mentioned at the outset, is achieved in that, by means of an identification unit, an excitation signal is generated, the excitation signal comprising at least one excitation-signal-component with a pre-defined excitation-component-frequency, in that, during an identification interval, said excitation signal is applied to said electrochemical energy storage and a response signal of the electrochemical energy storage responsive to the excitation signal is measured, the identification interval being at least as long as a signal period of the at least one excitation-signal-component, and in that a first cost function value of a cost function describing a deviation between a response-signal-component of the measured response signal at said excitation-component-frequency and the excitation-signal-component in the identification interval is determined. According to the invention, at least one correction factor to obtain a corrected-signal-component from the response-signal-component is further determined, a deviation between the corrected-signal-component and the excitation-signal-component in the identification interval being associated with a second cost function value of said cost function, the second cost function value being smaller than the first cost function value, and an impedance-value to describe the electrochemical energy storage at the excitation-component-frequency is determined from the at least one correction factor.

The purpose of the corrected-signal-component is to generate a signal whose deviation to the excitation-signal-component is smaller than the deviation of the response-signal-component. In terms of the cost function, this means that a deviation between the corrected-signal-component and the excitation-signal-component in the identification interval is associated with a second cost function value, the second cost function value being smaller than the first cost function value. From the at least one correction factor, an impedance-value to describe the electrochemical energy storage at the excitation-component-frequency is determined as the sought description of the electrochemical energy storage.

The ratio behind the invention is that an input or excitation signal is modified when it passes through a dynamical system, such as said electrochemical energy storage, in order to be turned into the response signal. A correction factor that - at least partially, preferred, however, entirely - reverts such a modification obviously describes at least a part of an inverse of the system that is to be identified, in the present case at least a part of an inverse of the electrochemical energy storage to be identified. Consequently, the impedance-value to describe the electrochemical energy storage at the excitation-component-frequency may, e.g., be determined from the at least one correction factor by inverting the at least one correction factor. The invention thus allows for an effective approach that may be implemented in simple fashion. As discussed in the following, the accuracy of the derived impedance value may be scaled and increased simply by repeating the steps outlined above multiple times, which allows to find a suitable trade-off between accuracy and computation complexity for any given situation the invention is applied in.

Preferably, the excitation signal is selected as a sinusoid with a pre-defined excitation-amplitude and a pre-defined excitation-phase-angle, the excitation-phase-angle, as it is typically the case in signal processing, preferably corresponding to a time shift from the beginning of the identification interval, i.e., the excitation-phase-angle preferably corresponding to a time shift between a starting time point of the identification interval and a time point in the identification interval of a first zero crossing of the sinusoid. Especially the use of sinusoids facilitates the analysis of the captured signals. In such a case, typically only one frequency needs to be analysed, and moreover, the broad range of tools available from linear signal and system analysis can be used to implement the invention.

As mentioned above, in case a further improvement of the determined impedance value is desired, a further correction factor to obtain a further corrected-signal-component from the corrected-signal-component may be determined, a deviation between the further corrected-signal-component and the excitation-signal-component in the identification interval being associated with a third cost function value of said cost function, the third cost function value being smaller than the second cost function value. The at least one correction factor and the further correction factor may then be used in a combined manner to obtain said impedance-value to describe the electrochemical energy storage at the excitation-component-frequency, or only the further correction factor may be used for that purpose.

With regards to scaling the accuracy of the method, it may as well be provided to determine a further correction factor until a cost function value associated with a further corrected-signal-component obtained with the further correction factor reaches a pre-defined threshold value. Such a threshold value may be used to express the desired accuracy, and the procedure may be stopped only when the desired accuracy is in fact reached.

In said embodiment, where a multiple of correction factors are being computed, a further, particularly beneficial option exists, where different types of correction factors may be used in order to reach a desired accuracy, such as a first correction factor being computed as a real-valued gain value, and another correction factor being computed as complex-valued phase shift value, the respective complex preferably having an absolute value of one. Specifically, at least one correction factor may be determined as a gain value, at least one further correction factor may be determined as a phase shift value and the at least one correction factor determined as a gain value and the at least one further correction factor determined as a phase shift value may be combined to obtain the impedance-value to describe the electrochemical energy storage at the excitation-component-frequency.

Of course, the method according to the invention may be repeated for a multiple of pre-defined excitation-component-frequencies, in order to obtain a multiple of impedance-values to describe the electrochemical energy storage. In a preferred manner, at least one of a nyquist plot or a bode diagram or a description of an electrical circuit diagram may be determined from the multiple of impedance-values as a model of the electrochemical energy storage. From a so-obtained description, i.e., e.g., Nyquist plot or a bode diagram, at least one of the SoH and the SoC of the electrochemical energy storage may be determined. However, SoH and / or SoC-values may already be derived from a single impedance-value as well, allowing for precise and detailed diagnosis of the storage already when computing just one impedance value. As laid out earlier, an impedance-value, or an SoH and/or SoC-value obtained from impedance-value, may be used to modify an operating strategy employed for operating the electrochemical energy storage.

The object is further achieved by said identification unit mentioned in the beginning, the identification unit being capable of carrying out the steps laid above, i.e., generating an excitation signal comprising at least one excitation-signal-component with a pre-defined excitation-component-frequency; during an identification interval, applying said excitation signal to said electrochemical energy storage and measure a response signal of the electrochemical energy storage responsive to the excitation signal, the identification interval being at least as long as a signal period of the at least one excitation-signal-component; determining a first cost function value of a cost function describing a deviation between a response-signal-component of the measured response signal at said excitation-component-frequency and the excitation-signal-component in the identification interval; determining at least one correction factor to obtain a corrected-signal-component from the response-signal-component, a deviation between the corrected-signal-component and the excitation-signal-component in the identification interval being associated with a second cost function value of said cost function, the second cost function value being smaller than the first cost function value; determining an impedance-value to describe the electrochemical energy storage at the excitation-component-frequency from the at least one correction factor.

Such an identification unit according to the invention may be used in a series of applications, e.g., in a cell tester for testing an electrochemical energy storage or an electrochemical cell, or in an arrangement of an identification unit according to the invention and an electrochemical energy storage.

Information obtained with the method according to the invention may be used in different ways, most preferably, however, it may be employed to design a control or operating strategy for an electrochemical energy storage. Specifically, in a control unit of an electrochemical energy storage to control at least one electrical quantity provided by the electrochemical energy storage at an output of the electrochemical energy storage to supply an electrical load, a model of the electrochemical energy storage based on an impedance value obtained by means of the invention may be provided, the control unit controlling said at least one electrical quantity on the basis of said model.

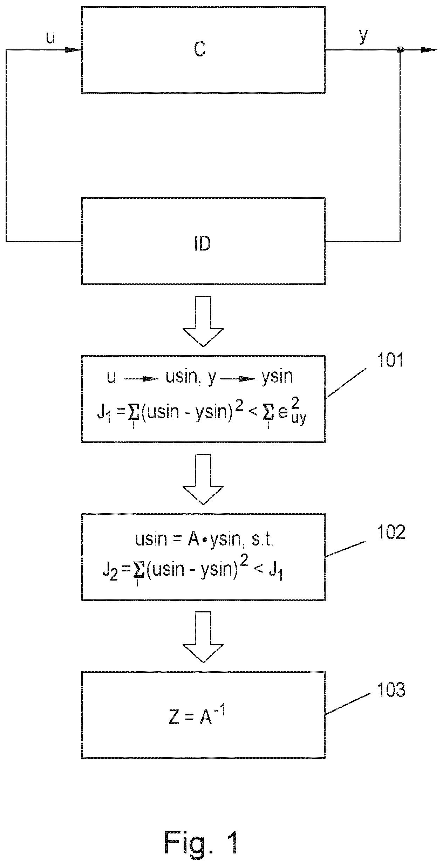

The present invention is described in greater detail below with reference to Figs.1 to 5, which show schematic and non-limiting advantageous embodiments of the invention by way of example. The specific examples described herein are only used to explain the content of the present invention and are not intended to limit the present embodiment. The following are shown:

Fig.1 an arrangement of an electrochemical energy storage and a cell tester to employ the identification method according to the invention,

Fig.2 signals occurring during the identification method,

Fig.3 a zoomed excerpt of the signals shown in Fig.2,

Fig.4a-4d possible models of an electrochemical energy storage obtainable with the identification method according to the invention,

Fig.5 an electrochemical energy storage having a control unit using a model obtained with the identification method according to the invention.

Fig.1, by way of example, shows an arrangement of an electrochemical energy storage C and an identification unit ID to identify the energy storage C. Arrangements to test and identify electrochemical energy storages C, such as primary batteries or secondary batteries or fuel cells or lithium-ion batteries are well-known in the prior art, e.g., from WO 2023/173154 A1 or US 9,465,077 B2. As mentioned previously, precise descriptions of electrochemical energy storages C are needed for a wide range of purposes, from monitoring SoC and/or SoH, to the planning of operation strategies, as well as to the design of control algorithms for an electrical energy storage C. An identification unit ID may be provided alone, as shown in Fig.1, or as part of a more complex system, preferably a so-called cell tester. Cell testers usually comprise a series of further components next to the identification unit ID, such as an elaborate CPU with automation software, several communication interfaces, additional measurement equipment, control units to control electrical quantities of the cell tester, etc., besides the components essential for identification.

The core steps in analyzing and identifying an electrochemical energy storage C by the means of an identification unit ID are as follows: In a first step, a first electrical quantity is applied to the electrochemical energy storage C, in many cases an electrical current. In a second step, a second electrical quantity is measured, in many cases an electrical voltage produced by the electrochemical energy storage C in response to the first electrical quantity. Of course, the first and second electrical quantity may as well both be electrical currents or both be electrical voltages, or the first electrical quantity may be an electrical voltage, and the second electrical quantity may be an electrical current. In a third step, a mathematical model of the electrochemical energy storage C is determined, using the information available about said first and second electrical quantity. Typically, such a model is constructed in the form of a description of an impedance of the electrochemical energy storage C. A model in the form of a description of an impedance may be given analytically, with a frequency-dependent, complex-valued impedance function, or numerically, e.g., in the form of vector containing impedance values for a finite selection of frequency values. In both cases, impedance models are oftentimes represented in the form of Nyquist plots or bode diagrams. In the numeric case, identifying an impedance model essentially consists of identifying a series of individual impedance values for said finite set of frequency values.

Impedance models as well as the procedure outlined above are common knowledge in the field of electrochemical energy storages, and are, e.g., described in detail in WO 2023/173154 A1 or US 9,465,077 B2. Implementation specifics related to the sensors, actuators, processing units etc. typically employed in an identification unit ID are therefore not discussed further at this point.

As mentioned at the outset, many of the classical approaches known from the prior art, e.g., from US 10,386,422 B2, US 10,345,384 B2, WO 2023/173154 A1 or US 9,465,077 B2, suffer from certain drawbacks, especially when it comes to quickly, reliably and efficiently identifying a model of an electrochemical energy storage C. Oftentimes, these drawbacks are associated with high computation complexity, or with a lack of precision and/or flexibility.

To overcome these deficiencies, the present invention proposes an identification method for models of an electrochemical energy storage C that is simple to use, but still allows to produce precise and reliable results. With reference to Fig.1, the identification method according to the invention may be described as follows: Firstly, an excitation signal u is generated, the excitation signal u comprising at least one excitation-signal-component usin with a pre-defined excitation-component-frequency fu. During an identification interval I, this excitation signal u is applied to the electrochemical energy storage C, whereupon a response signal y of the electrochemical energy storage C responsive to the excitation signal u is measured.

Secondly, as in the prior art referred to above, information about the excitation signal u and the response signal y is used to identify a description of the electrochemical energy storage C. According to the invention, said description is determined differently, however, when compared to the classical approaches discussed so far.

Specifically, within the scope of the present invention, a first cost function value $J_1$ of a cost function J is determined, the cost function value $J_1$ describing a deviation $e_{uy}$, which may correspond to a cost function

$$J = \sum e_i^2$$

, between the excitation-signal-component usin and a response-signal-component ysin of the measured response signal y at said excitation-component-frequency fu. After determining the cost function value Ji, the invention provides to determine at least one correction factor A1 to obtain a corrected-signal-component rsin from the response-signal-component ysin.

The purpose of the corrected-signal-component rsin is to generate a signal whose deviation $e_{ur}$ to the excitation-signal-component usin is smaller than the deviation of the response-signal-component ysin. In terms of the cost function J, this means that a deviation $e_{ur}$ between the corrected-signal-component rsin and the excitation-signal-component usin in the identification interval I is associated with a second cost function value $J_2$, the second cost function value $J_2$ being smaller than the first cost function value, i.e., $J_2 < J_1$, as pointed out in block 102 of Fig.1. From the at least one correction factor A1, an impedance-value Z to describe the electrochemical energy storage C at the excitation-component-frequency fu is determined as the sought description of the electrochemical energy storage C.

The ratio behind the outlined procedure is that an input or excitation signal u is modified when it passes through a dynamical system, such as the electrochemical energy storage C discussed presently, in order to be turned into a response signal y, as is known from basic systems theory. A correction factor A1 that - at least partially, preferred, however, entirely - reverts such a modification obviously describes at least a part of an inverse of the system that is to be identified, in the present case at least a part of an inverse of the electrochemical energy storage C to be identified. Consequently, the impedance-value Z to describe the electrochemical energy storage C at the excitation-component-frequency fu may be determined from the at least one correction factor A1 by inverting the at least one correction factor A1, as pointed out in block 103 of Fig.1. However, this is by no means the only way to compute said impedance-value Z from the at least one correction factor / gain A1.

To obtain the corrected-signal-component rsin from the response-signal-component ysin, the response-signal-component ysin may be multiplied by the correction factor A1, as suggested in block 102 of Fig.1. This is especially true if the correction factor A1 corresponds to a gain value or a complex number, e.g., representing an admittance of the energy storage C. However, in case the correction factor A1 corresponds to a phase angle, a shifting operation of the response-signal-component ysin by a shifting interval corresponding to the phase angle may be appropriate. All of these options are possible and may be combined with one another, as will be discussed in detail later.

As is well-known, an impedance value at a given frequency describes a gain value and a phase shift, which is often represented by a single complex number. In a particularly beneficial way, a correction factor A1 may thus correspond to a complex number representing an admittance and thus a gain and phase shift in one. Within the scope of the present invention, it is, however, also possible to identify gain and phase shift separately and combine these results at a later stage.

In a preferred embodiment, the cost function J may be a sum of squared errors $e_{uy}^2$ of the identification interval I, as indicated in block 101 of Fig.1. However, also other implementations / versions of a cost function J may be used, such as a cost function J based on a different norm, e.g., the 1-norm or the 3-norm or the ∞-norm of the deviation between excitation-signal-component usin and response-signal-component ysin. This variability allows for great flexibility when adapting the invention to a specific use case.

In the course of the invention, it was found that electrochemical energy storages C, such as primary batteries or secondary batteries or fuel cells or lithium-ion batteries, do not comprise transfer zeros. As is well-known from control theory, a transfer zero corresponds to a gain value of zero for a specific excitation frequency, causing a response-signal-component ysin to vanish in case an excitation-component-frequency fu coincides with such a zero-frequency. Clearly, this would be problematic in the course of the invention, as it is not possible to scale a signal with vanishing magnitude by a finite correction factor to generate any other signal at all. However, as it was found that electrochemical energy storages C do not comprise such zeros, electrochemical energy storages C are an ideal field of application for the identification method according to the invention.

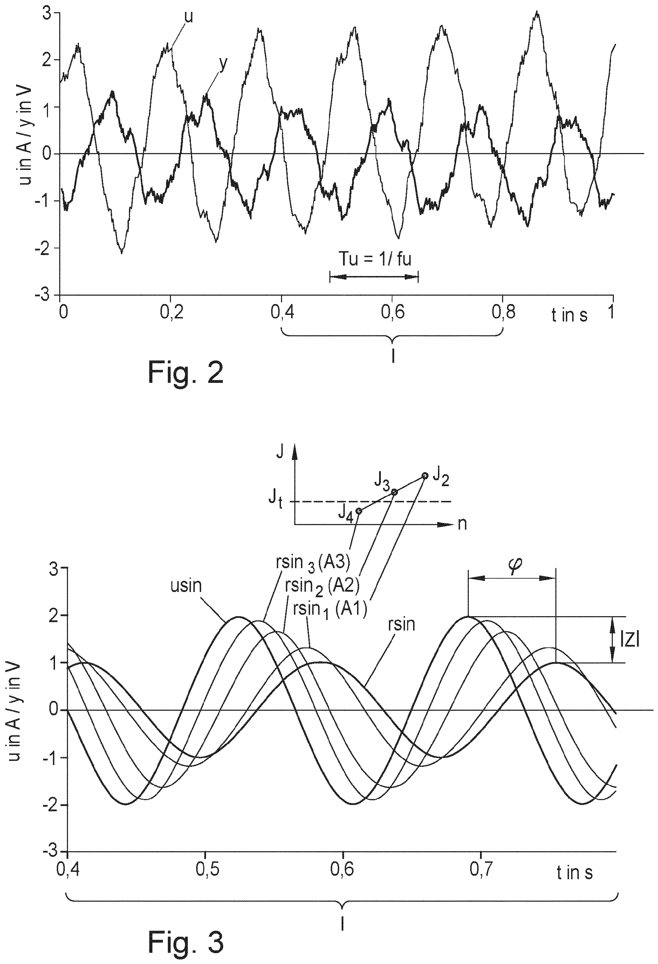

What the signals referred to so far (u, y, usin, ysin) may look like is, by way of example, shown in Fig.2. Generally, it is of course desirable to immediately chose the excitation signal u as a pure sinusoid with a pre-defined excitation-amplitude U and a pre-defined excitation-phase-angle uphi, the excitation-phase-angle uphi preferably corresponding to a time shift from the beginning of the identification interval I. In such a case, the excitation signal u would, as a whole, correspond to the excitation-signal-component usin, the excitation-signal-component usin hence being a pure sinusoid as well, and it would no longer be necessary to filter out or extract the excitation-signal-component usin from the excitation signal u.

However, as can be seen from Fig.2, in practice, signals usually do not comprise just on frequency component, but a series of frequency components as well as signal drift, and are, in particular, superimposed with signal noise. Thus, the preferred selection as pure sinusoid typically is not possible. To that end, the invention allows to apply an excitation signal u that may comprise an extended series of excitation-signal-components usin, i.e., a multiple of frequency components, as is known from Fourier analysis, and also to measure a response-signal y containing an extended series of response-signal-components ysin. To be able to focus on just one frequency component, both the excitation signal u as well as the response signal y may be filtered, e.g., by an appropriately tuned band-pass-filter, to extract the signal component of interest from each signal u, y.

Further, another important prerequisite of the invention can be seen clearly Fig.2, i.e., that the identification interval I is at least as long as a signal period Tu of the at least one excitation-signal-component usin. As is well-known from signal processing, measurement / identification intervals shorter than a periodic signal's period can be problematic when it comes to analyzing said signal.

How an excerpt of both an excitation signal u and of a response signal y from the identification interval I shown in Fig.2 may be processed is further shown in Fig.3. Specifically, Fig.3 displays an excitation-signal-component usin extracted from the excitation signal u shown in Fig.2, as well as a response-signal-component ysin of the measured response signal y at said excitation-component-frequency fu. As said before, such an extraction of signal components may, for instance, be carried out by the means of an appropriately tuned band pass filter, or by another filter.

Referring again to the reasoning behind the invention, it is desirable to find a correction factor A1 which allows to obtain a corrected-signal-component rsin from the response-signal-component ysin that gets to the excitation-signal-component usin as close as possible. In case the excitation-signal-component usin and the corrected-signal-component rsin coincide, a corresponding correction factor A1 would perfectly describe the inverse of the impedance Z (thus the admittance) at the respective excitation-component-frequency fu. However, in practice, it is usually not possible to find a perfect correction factor A1 immediately.

In such a case, it is oftentimes beneficial to proceed step-by-step, in order to gradually improve a correction factor A1 and hence an impedance value Z associated with said correction factor A1. Specifically, to that end and within the scope of the invention, it may be provided that a further correction factor A2 to obtain a further corrected-signal-component rsin2 from the corrected-signal-component rsin is determined, a deviation $e_{ur2}$ between the further corrected-signal-component rsin2 and the excitation-signal-component usin in the identification interval I being associated with a third cost function value $J_3$ smaller than the second cost function value, i.e., $J_3 < J_2$, and that the least one correction factor A1 and the further correction factor A2 are combined to obtain said impedance-value Z to describe the electrochemical energy storage C at the excitation-component-frequency fu. In this process, for instance, the at least one correction factor A1 and the further correction factor A2 may be multiplied or added or combined in another possible way to obtain the sought impedance-value Z. The at least one correction factor A1 may in such a case correspond to an absolute value |Z| of the impedance, and the further correction factor A2 may correspond to a phase-shift angle $\varphi$, as depicted in Fig.3.

Apparently, this procedure, i.e., consecutively determining a further correction factor An, may be repeated until a cost function value Jn associated with a further corrected-signal-component rsin obtained with the further correction factor An underpasses a pre-defined threshold value $J_t$, as shown in Fig.3. In Fig.3, it is apparent that the correction-signals gradually get closer to the excitation-signal-component usin, the error and thus the associated cost function value Jn getting smaller.

In a particularly beneficial embodiment of the invention, at least one correction factor A1 may be determined as a gain value |Z|, at least one further correction factor An may be determined as a phase shift value $\varphi$, such that the at least one correction factor A1 determined as a gain value |Z| and the at least one further correction factor An determined as a phase shift value $\varphi$ may be combined, e.g., by computing a corresponding admittance, to eventually obtain said impedance-value Z to describe the electrochemical energy storage C at the excitation-component-frequency fu.

Clearly, one is typically interested in more than just a single impedance value Z for just one single frequency fu. Beneficially, the method according to the invention may hence be repeated for a multiple of pre-defined excitation-component-frequencies fu in order to obtain a multiple of impedance-values Z to describe the electrochemical energy storage C.

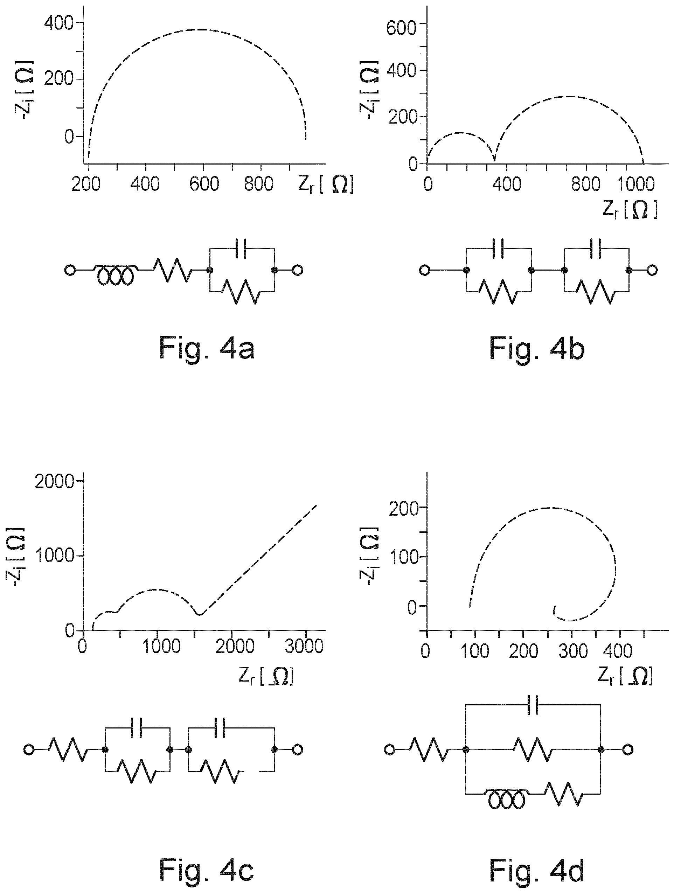

In a particularly preferred manner, from such a multiple of impedance-values Z, a Nyquist plot or a bode diagram or a description in the form of an electrical circuit diagram may be determined. Possible Nyquist plots, that may be the outcome of this procedure, are further shown in Figs.4a-d. As is well known in the field of electrochemical energy storages C, certain shapes and certain forms of a Nyquist plot describing an electrochemical energy storage C are associated with certain electrical circuit diagrams. In Figs.4a-d, electrical circuit diagrams corresponding to the presented Nyquist plots are shown directly below the respective Nyquist plots.

Information gathered by the means of the present invention and represented, preferably in the form of Nyquist plot as in Figs.4a-d or in the form of a circuit diagrams, may be used in a series of different ways when operating an electrochemical energy storage C. For instance, at least one of the SoH and the SoC of the electrochemical energy storage C may be determined from the at least one impedance-value Z and/or from a corresponding Nyquist plot, upon which an operating strategy of the electrochemical energy storage C may be modified. For that purpose, an aforementioned model, e.g., in the form of a Nyquist plot, may be stored in a control unit R of an electrochemical energy storage C.

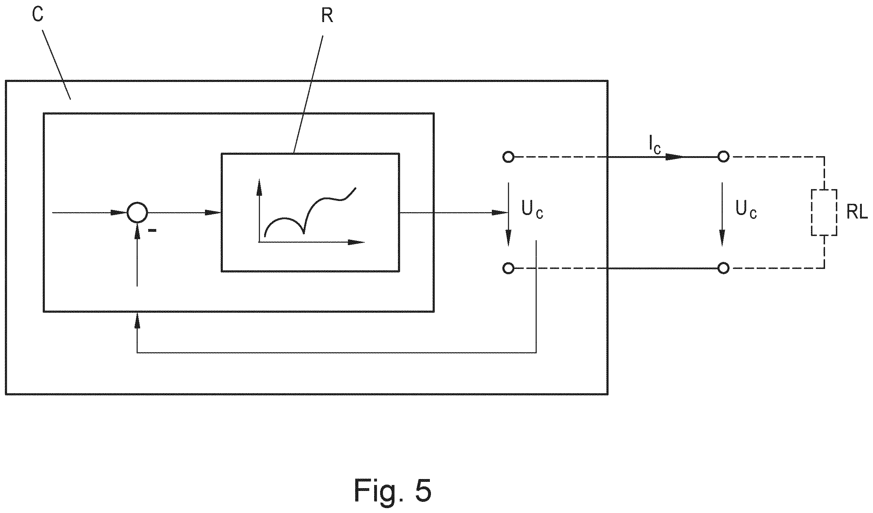

Specifically, as shown in Fig.5 and within the scope of this invention, an electrochemical energy storage C may be provided, comprising a control unit R to control at least one electrical quantity U, I (electrical current or voltage) provided by the electrochemical energy storage C at an output of the electrochemical energy storage C to supply an optional electrical load RL, wherein a model of the electrochemical energy storage C based on an impedance value obtained by the method according to the invention is provided in the control unit R, such that the control unit R is capable of controlling said at least one electrical quantity U, I on the basis of the model, or on the basis of a control algorithm, e.g., a PID-controller or a flatness-based controller or a model-predictive-controller, derived from said model. As is well-known in the prior art, said control unit R may be implemented in the form of, inter alia, microprocessor-based hardware, microcontrollers, or integrated circuits (ASIC, FPGA). Within this embodiment, in a particularly beneficial embodiment, it may even be provided to adapt such a control algorithm based on an impedance value identified within the scope of the invention, in case a new and / or updated impedance value Z is available.

**Claims**

1. A method for identifying an impedance-value (Z) of an electrochemical energy storage (C), the method comprising the steps of:

   (a) using an identification unit (ID) to generate an excitation signal (u) comprising at least one excitation-signal-component (usin) with a pre-defined excitation-component-frequency (fu);

   (b) during an identification interval (I), applying said excitation signal (u) to said electrochemical energy storage (C) and measuring a response signal (y) of the electrochemical energy storage (C) responsive to the excitation signal (u), the identification interval (I) being at least as long as a signal period of the at least one excitation-signal-component (usin);

   (c) determining a first cost function value ($J_1$) of a cost function (J) describing a deviation ($e_{uy}$) between a response-signal-component (ysin) of the measured response signal (y) at said excitation-component-frequency (fu) and the excitation-signal-component (usin) in the identification interval (I);

   (d) determining at least one correction factor (A1) to obtain a corrected-signal-component (rsin) from the response-signal-component (ysin), a deviation ($e_{ur}$) between the corrected-signal-component (rsin) and the excitation-signal-component (usin) in the identification interval (I) being associated with a second cost function value ($J_2$) of said cost function (J), the second cost function value (J2) being smaller than the first cost function value ($J_2 < J_1$);

   (e) determining an impedance-value (Z) to describe the electrochemical energy storage (C) at the excitation-component-frequency (fu) from the at least one correction factor (A1).

2. The method according to claim 1, **characterized in that** the excitation signal (u) is a sinusoid with a pre-defined excitation-amplitude (U) and a pre-defined excitation-phase-angle (uphi), the excitation-phase-angle (uphi) preferably corresponding to a time shift between a starting time point of the identification interval (I) and a time point of a first zero crossing of the sinusoid in the identification interval (I).

3. The method according to any one of claims 1 or 2, **characterized in that** a further correction factor (A2) to obtain a further corrected-signal-component (rsin2) from the corrected-signal-component (rsin) is determined, a deviation ($e_{ur2}$) between the further corrected-signal-component (rsin2) and the excitation-signal-component (usin) in the identification interval (I) being associated with a third cost function value ($J_3$) of said cost function (J), the third cost function value ($J_3$) being smaller than the second cost function value ($J_3 < J_2$), **and in that** the least one correction factor (A1) and the further correction factor (A2) are combined to obtain said impedance-value (Z) to describe the electrochemical energy storage (C) at the excitation-component-frequency (fu).

4. The method according to claim 3, **characterized in that** a further correction factor (A2, An) is determined until a cost function value (Jn) associated with a further corrected-signal-component (rsin) obtained with the further correction factor (A2, An) reaches or underpasses a pre-defined threshold value (Jt).

5. The method according to any one of the previous claims, **characterized in that** at least one correction factor (A1) is determined as a gain value ($|Z|$), **in that** at least one further correction factor (A2, An) is determined as a phase shift value ($\varphi$) **and in that** the at least one correction factor (A1) determined as a gain value ($|Z|$) and the at least one further correction factor (A2, An) determined as a phase shift value ($\varphi$) are combined to obtain the impedance-value (Z) to describe the electrochemical energy storage (C) at the excitation-component-frequency (fu).

6. The method according to any one of the previous claims, **characterized in that** the method is repeated for a multiple of pre-defined excitation-component-frequencies (fu) in order to obtain a multiple of impedance-values (Z) to describe the electrochemical energy storage (C).

7. The method according to claim 6, **characterized in that** at least one of a Nyquist plot or a Bode diagram or a description of an electrical circuit diagram is determined from the multiple of impedance-values (Z) as a model of the electrochemical energy storage (C).

8. The method according to any one of the previous claims, **characterized in that** at least one of the state-of-health (SoH) and the state-of-charge (SoC) of the electrochemical energy storage (C) is determined from the at least one impedance-value (Z).

9. The method according to any one of the previous claims, **characterized in that** the impedance-value (Z) to describe the electrochemical energy storage (C) at the excitation-component-frequency (fu) is determined from the at least one correction factor (A1) by inverting said at least one correction factor (A1).

10. Method for operating an electrochemical energy storage (C), **characterized in that** an impedance-value (Z) obtained by any one of the previous claims is used to modify an operating strategy and/or a control law employed for operating the electrochemical energy storage (C).

11. Identification unit (ID) for identifying an electrochemical energy storage (C), the identification unit (ID) being designed to

  ○ generate an excitation signal (u) comprising at least one excitation-signal-component (usin) with a pre-defined excitation-component-frequency (fu);
  ○ during an identification interval (I), apply said excitation signal (u) to said electrochemical energy storage (C) and measure a response signal (y) of the electrochemical energy storage (C) responsive to the excitation signal (u), the identification interval (I) being at least as long as a signal period of the at least one excitation-signal-component (usin);
  ○ determine a first cost function value ($J_1$) of a cost function (J) describing a deviation ($e_{uy}$) between a response-signal-component (ysin) of the measured response signal (y) at said excitation-component-frequency (fu) and the excitation-signal-component (usin) in the identification interval (I);
  ○ determine at least one correction factor (A1) to obtain a corrected-signal-component (rsin) from the response-signal-component (ysin), a deviation ($e_{ur}$) between the corrected-signal-component (rsin) and the excitation-signal-component (usin) in the identification interval (I) being associated with a second cost function value ($J_2$) of said cost function (J), the second cost function value (J2) being smaller than the first cost function value ($J_2 < J_1$);
  ○ determine an impedance-value (Z) to describe the electrochemical energy storage (C) at the excitation-component-frequency (fu) from the at least one correction factor (A1).

12. A cell tester (T) for testing an electrochemical energy storage (C) or an electrochemical cell, the cell tester (T) comprising an identification unit (ID) according to claim 11.

13. An arrangement of an identification unit (ID) according to claim 11 and an electrochemical energy storage (C).

14. An electrochemical energy storage (C), comprising a control unit (R) to control at least one electrical quantity (U, I) provided by the electrochemical energy storage (C) at an output of the electrochemical energy storage (C) to supply an electrical load (RL), **characterized in that** a model of the electrochemical energy storage (C) based on an impedance value (Z) obtained by any one of claims 1 to 9 being provided in the control unit (R), the control unit (R) controlling said at least one electrical quantity (U, I) on the basis of said model or on the basis of a control algorithm derived from said model.

15. Electrochemical energy storage (C) according to claim 14, the electrochemical energy storage (C) being a primary battery or a secondary battery or a fuel cell or a lithium-ion battery.

$$u \longrightarrow usin, \; y \longrightarrow ysin$$
$$J_1 = \sum_i (usin - ysin)^2 < \sum_i e_{uy}^2 \quad 101$$

$$usin = A \cdot ysin, \; s.t.$$
$$J_2 = \sum_i (usin - ysin)^2 < J_1 \quad 102$$

$$Z = A^{-1} \quad 103$$

Fig. 1

EP 4 632 401 A1

Fig. 2

Fig. 3

Fig. 4a

Fig. 4b

Fig. 4c

Fig. 4d

Fig. 5

## EUROPEAN SEARCH REPORT

Application Number

EP 24 16 9779

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DE 10 2019 129449 A1 (BAYERISCHE MOTOREN WERKE AG [DE]) 6 May 2021 (2021-05-06) * paragraph [0015] - paragraph [0018]; claim 1; figure 1 * | 1-15 | INV. G01R31/367 G01R31/389 G01R31/392 H01M10/48 |
| A | US 2022/206076 A1 (MORRISON JOHN [US]) 30 June 2022 (2022-06-30) * paragraphs [0094], [0159], [0160] * | 1-15 | |
| A | US 2019/317152 A1 (BALLANTINE ARNE [US] ET AL) 17 October 2019 (2019-10-17) * paragraph [0039]; claims 1-3 * | 1-15 | |

TECHNICAL FIELDS
SEARCHED     (IPC)

G01R
H01M

The present search report has been drawn up for all claims

| Place of search | Date of completion of the search | Examiner |
|---|---|---|
| Munich | 24 September 2024 | O'Callaghan, D |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

& : member of the same patent family, corresponding
     document

EPO FORM 1503 03.82 (P04C01)

**ANNEX TO THE EUROPEAN SEARCH REPORT
ON EUROPEAN PATENT APPLICATION NO.**

EP 24 16 9779

This annex lists the patent family members relating to the patent documents cited in the above-mentioned European search report.
The members are as contained in the European Patent Office EDP file on
The European Patent Office is in no way liable for these particulars which are merely given for the purpose of information.

24-09-2024

| Patent document cited in search report | Publication date | Patent family member(s) | Publication date |
|---|---|---|---|
| DE 102019129449 A1 | 06-05-2021 | CN 114585937 A | 03-06-2022 |
| | | DE 102019129449 A1 | 06-05-2021 |
| | | JP 2022554084 A | 28-12-2022 |
| | | KR 20220059961 A | 10-05-2022 |
| | | US 2022365142 A1 | 17-11-2022 |
| | | WO 2021083813 A1 | 06-05-2021 |
| US 2022206076 A1 | 30-06-2022 | US 2022206076 A1 | 30-06-2022 |
| | | WO 2020223651 A1 | 05-11-2020 |
| US 2019317152 A1 | 17-10-2019 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10345384 B2
- US 10386422 B2
- WO 2023173154 A1
- US 9465077 B2